# EUROPEAN PATENT APPLICATION

(11) **EP 4 789 820 A1**
(43) Date of publication of application: **12.08.2026**
(21) Application number: 24874276.9
(22) Date of filing: 25.01.2024
(51) Int. Cl.: B25J 9/06

(54) **HANDLING ROBOT, TRANSFER CHAMBER, AND SEMICONDUCTOR MANUFACTURING APPARATUS**

(30) Priority: 06.10.2023 JP 2023174112
(71) Applicant: Rorze Corporation, Fukuyama-shi, Hiroshima 720-2104 (JP)
(72) Inventor: ISHII, Takashi, Fukuyama-shi, Hiroshima 7202104 (JP)
(74) Representative: Schäfer, Matthias W.
(86) International application number: PCT/JP2024/002134
(87) International publication number: WO 2025/074656

(57) **Abstract**

There is provided a handling robot capable of transporting a workpiece over a longer distance without increasing a turning radius of a robot, and further, when the handling robot is mounted in a transfer chamber, capable of safely transporting the workpiece without colliding with a gate formed in the transfer chamber, even if the gate has a small width dimension. A handling robot includes a first arm; a second arm; a first link having a proximal end portion rotatably connected to a distal end portion of the first arm; a second link having a proximal end portion rotatably connected to a distal end portion of the second arm; and a first holding finger for holding a workpiece. The first link and the second link are disposed at height positions different from each other in a vertical direction. Each of the first link and the second link has a shape including a portion curved in a direction opposite to a forward rotation direction for moving the first holding finger in plan view.

## Description

### TECHNICAL FIELD

The present invention relates to a handling robot that is disposed in a transfer chamber of a manufacturing apparatus, such as a flat panel display manufacturing apparatus or a semiconductor manufacturing apparatus 36, in which a plurality of process chambers are disposed around one transfer chamber, and that transports a workpiece W having a thin plate shape. The handling robot transports the workpiece W having a thin plate shape, such as a wafer to be processed in each process chamber, to each of the process chambers via the transfer chamber.

### BACKGROUND ART

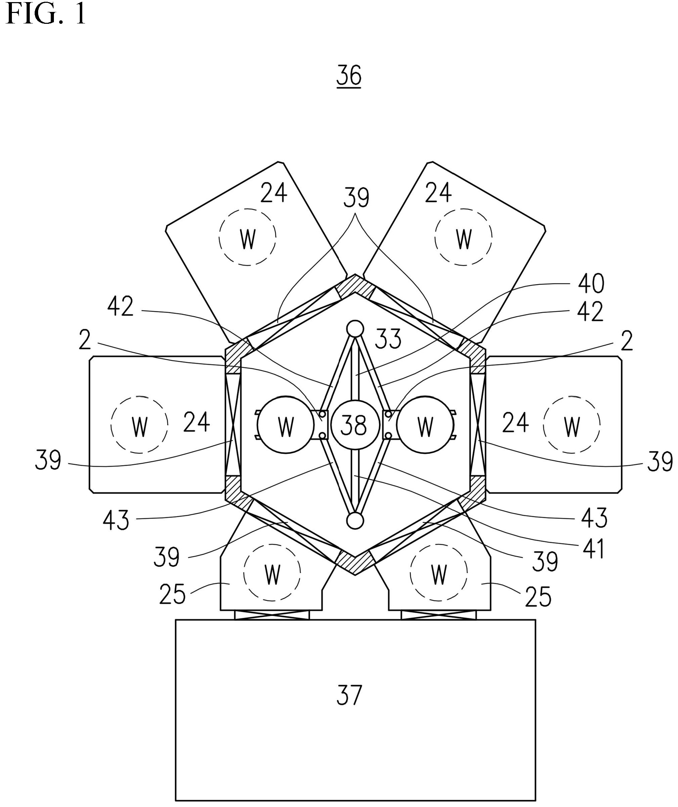

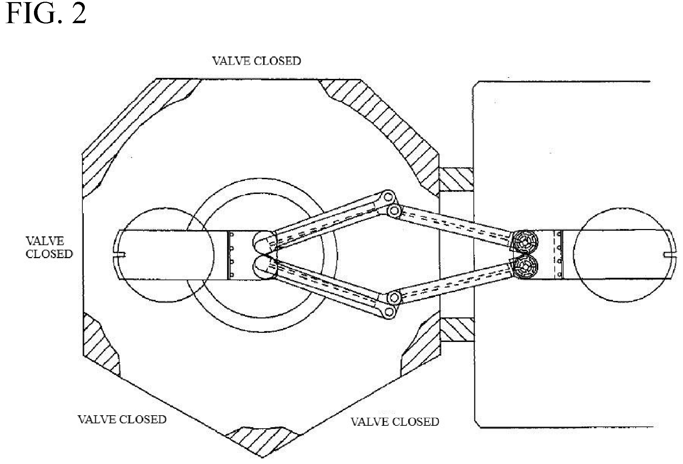

Hereinafter, a conventional handling robot will be described, taking the semiconductor manufacturing apparatus 36 illustrated in Figs. 1 and 2 as an example. In the semiconductor manufacturing apparatus, as illustrated in Fig. 1, a load lock station 25 that performs the transfer of the workpiece W between a plurality of process chambers 24 and a wafer transport device 37 is disposed around a transfer chamber 33. The interiors of the transfer chamber 33 and the process chambers 24 are switched between a vacuum atmosphere and an atmospheric pressure atmosphere by an atmosphere maintaining device (not illustrated), and the state is maintained. A wafer handling robot 38 is provided at a central portion of the transfer chamber 33. A gate 39 serving as an entrance and exit for the workpiece W is provided in each of a wall isolating each of the process chambers 24 from the transfer chamber 33 and a wall isolating the load lock station 25 from the transfer chamber 33. The gate 39 is switched between an open state and a closed state by a partition member referred to as a gate valve.

The wafer handling robot 38 includes a known arm body referred to as a so-called frog-leg arm. The frog-leg arm includes two arms 40 and 41 having a linear shape and the same length and extending in opposite directions with respect to the center of rotation at the center. Links 42 and 43 are connected to the respective distal end portions of the two arms 40 and 41, and a holding finger 2 is connected to the distal ends of the links 42 and 43. Incidentally, in Figs. 1 and 2, two links 42 and two links 43 are connected to the distal end portions of the arms 40 and 41, respectively, and two fingers are provided at the distal ends of the links. The rotational operations of the respective arms 40 and 41 cause the arms 40 and 41 and the links 42 and 43 to perform a bending and extending operation in cooperation with each other, thereby allowing the holding fingers 2, which are connected to the distal end portions of the links 42 and 43, to advance and retract in a horizontal plane. The respective distal end portions of the two links 42 and the two links 43 are connected to the holding fingers 2 via known finger posture regulating mechanisms, and the holding fingers 2 moves forward and backward while maintaining predetermined postures.

As illustrated in Fig. 2, the wafer handling robot 38 operates each of the arms 40 and 41 to hold the workpiece W carried to the load lock station 25 by the transport device 37, transport the workpiece W into the transfer chamber 33, and then transport the workpiece W to a predetermined process chamber 24. In addition, when the processing of the workpiece W in the process chamber 24 is completed, the wafer handling robot 38 operates each of the arms 40 and 41 to retrieve the workpiece W for which the processing is completed from the process chamber 24, and then return the processed workpiece W to the load lock station 25.

The semiconductor manufacturing apparatus 36 is required to minimize its occupied area as much as possible in the semiconductor factory where the semiconductor manufacturing apparatus 36 is installed. Furthermore, since the interior of the transfer chamber 33 needs to be switched to a vacuum atmosphere in as short a time as possible, the transfer chamber 33 is required to have as small a volume as possible, and from the viewpoint of reducing the size of the transfer chamber 33, the wafer handling robot 38 with each of the arms 40 and 41 having a smaller turning radius is required. On the other hand, for example, semiconductor wafers have increased in size from 200 mm to 300 mm in diameter, and accordingly, the process chambers 24 and the load lock station 25 have also increased in size. Therefore, the wafer handling robot 38 that transports semiconductor wafers is required to transport the semiconductor wafers over a longer distance.

Incidentally, the width and height dimensions of the gates 39 provided between the transfer chamber 33 and the process chambers 24 and the transfer chamber 33 and the load lock station 25 are specified by the semiconductor equipment and materials international (SEMI) standards, which are international standards for the semiconductor manufacturing apparatus 36 and the materials field, and in the case of a semiconductor wafer having a diameter of 300 mm, the width dimension is specified to be a maximum of 336 mm, and the height dimension is specified to be 50 mm.

### CITATION LIST

### PATENT DOCUMENT

Patent Document 1: JP 3419457 B2

### DISCLOSURE OF THE INVENTION

### PROBLEM TO BE SOLVED BY THE INVENTION

Here, a significant problem arises when attempting to address the conflicting requirements of miniaturizing the wafer handling robot 38 and extending the transport distance of semiconductor wafers. When attempting to reduce the footprint of the transfer chamber 33, there is a possibility that the links 42 and 43 of the frog-leg type wafer handling robot 38 come into contact with side surfaces of the gates 39 formed between the transfer chamber 33 and the process chambers 24 and between the transfer chamber 33 and the load lock station 25. Therefore, when the frog-leg type wafer handling robot 38 is used, the distance between the wafer handling robot 38 and the gates 39 needed to be increased such that each of the links 42 and 43 of the wafer handling robot 38 and the gates 39 do not collide with each other. Furthermore, in order to increase the transport distance of semiconductor wafers, it was necessary to lengthen each of the arms 40 and 41 of the wafer handling robot 38 and each of the links 42 and 43. Therefore, the footprint of the transfer chamber 33 that accommodates the wafer handling robot 38 could not be reduced.

The invention has been devised in view of the above-described problems, and an object of the invention is to provide a handling robot capable of transporting a workpiece over a longer distance without increasing a turning radius of a robot, and further, when the handling robot is disposed in a transfer chamber, capable of safely transporting the workpiece without colliding with a gate formed in the transfer chamber, even if the gate has a small width dimension.

### MEANS FOR SOLVING PROBLEM

A handling robot according to the invention, which is devised to solve the above-described problems, includes: a first arm and a second arm, each having a proximal end portion coupled to a drive mechanism; a first link having a proximal end portion rotatably connected to a distal end portion of the first arm; a second link having a proximal end portion rotatably connected to a distal end portion of the second arm; and a first holding finger for holding a workpiece. Each of a distal end portion of the first link and a distal end portion of the second link is rotatably connected to a proximal end portion of the first holding finger. The first link and the second link are disposed at height positions different from each other in a vertical direction. Each of the first link and the second link has a shape including a portion curved in a direction opposite to a forward rotation direction for moving the first holding finger forward in plan view.

In addition, the handling robot according to the invention further includes a third link having a proximal end portion rotatably connected to the distal end portion of the first arm; a fourth link having a proximal end portion rotatably connected to the distal end portion of the second arm; and a second holding finger for holding a workpiece. Each of a distal end portion of the third link and a distal end portion of the fourth link is rotatably connected to a proximal end portion of the second holding finger. The third link and the fourth link are disposed at height positions different from each other in the vertical direction. Each of the third link and the fourth link has a shape including a portion curved in a direction opposite to a forward rotation direction for moving the second holding finger forward in plan view.

Here, a configuration in which the first link and the third link are disposed at height positions different from each other in the vertical direction and the second link and the fourth link are disposed at height positions different from each other in the vertical direction may be employed. In addition, a shape of the curved portion may include a portion extending in the direction opposite to the forward rotation direction and a portion extending in the forward rotation direction in plan view, and the curved portion may have an arc shape in plan view.

In addition, the first link and the second link may have shapes symmetrical to each other in plan view, and the third link and the fourth link may have shapes symmetrical to each other in plan view. Furthermore, the third link may have a shape symmetrical to the first link in plan view, and the fourth link may have a shape symmetrical to the second link in plan view.

In addition, each of the first link and the third link may be connected to the distal end portion of the first arm so as to be rotatable about a common rotation axis serving as a center of rotation, and each of the second link and the fourth link may be connected to the distal end portion of the second arm so as to be rotatable about a common rotation axis serving as a center of rotation.

Furthermore, the first arm may have the distal end portion branching, the proximal end portion of the first link may be connected to one branch of the distal end portion of the first arm, and the proximal end portion of the third link may be connected to the other branch of the distal end portion of the first arm. The second arm may have the distal end portion branching, the proximal end portion of the second link may be connected to one branch of the distal end portion of the second arm, and the proximal end portion of the fourth link may be connected to the other branch of the distal end portion of the second arm.

In the above-described configuration, the first link and the third link may be disposed at the same height position, and the second link and the fourth link may be disposed at the same height position.

In addition, the drive mechanism provided in the handling robot according to the invention may include a first direct drive motor and a second direct drive motor as drive sources. The first direct drive motor and the second direct drive motor may be configured to rotate about a common rotation axis serving as a center of rotation. Furthermore, a configuration in which a first shaft and a second shaft are rotatable about respective rotation axes serving as centers of rotation and extending in the vertical direction, the proximal end portion of the first arm is fixed to a distal end portion of the first shaft, and the proximal end portion of the second arm is fixed to a distal end portion of the second shaft may be employed.

### EFFECT OF THE INVENTION

According to the handling robot of the invention, a workpiece can be safely transported even when a gate has a lateral width dimension through which a conventional frog-leg arm cannot pass. Furthermore, since the respective links do not collide with each other, a workpiece can be transported over a long distance without increasing the size of each arm or each link.

### BRIEF DESCRIPTION OF DRAWINGS

Fig. 1 is a view illustrating a semiconductor manufacturing apparatus;
Fig. 2 is a view illustrating a conventional frog-leg robot;
Fig. 3 is a view illustrating a handling robot, which is one embodiment of the invention;
Fig. 4 is a view illustrating one embodiment of a drive mechanism provided in the handling robot of the invention;
Fig. 5 is a view illustrating a finger posture regulating mechanism;
Fig. 6 is a view illustrating an operation of the handling robot, which is one embodiment of the invention;
Fig. 7 is a view illustrating an operation of the handling robot, which is one embodiment of the invention;
Fig. 8 is a view illustrating other embodiments of links provided in the handling robot of the invention;
Fig. 9 is a view illustrating a handling robot, which is one embodiment of the invention;
Fig. 10 is a view illustrating the handling robot, which is one embodiment of the invention;
Fig. 11 is a view illustrating an operation of the handling robot, which is one embodiment of the invention;
Fig. 12 is a view illustrating an operation of the handling robot, which is one embodiment of the invention;
Fig. 13 is a view illustrating an operation of the handling robot, which is one embodiment of the invention;
Fig. 14 is a view illustrating other embodiments of the drive mechanism provided in the handling robot of the invention;
Fig. 15 is a view illustrating a handling robot, which is one embodiment of the invention;
Fig. 16 is a view illustrating a handling robot, which is one embodiment of the invention;

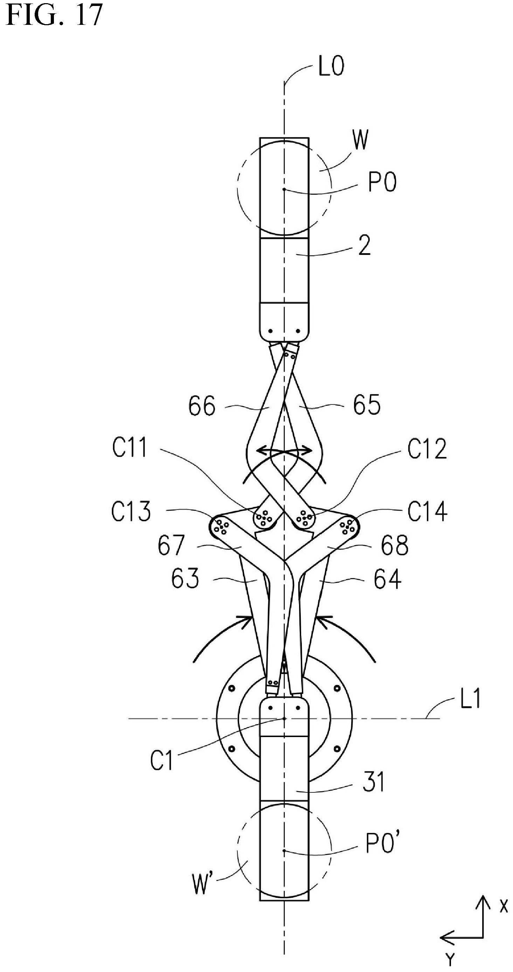

Fig. 17 is a view illustrating an operation of the handling robot, which is one embodiment of the invention; and
Fig. 18 is a view illustrating a handling robot, which is one embodiment of the invention.

### BEST MODES FOR CARRYING OUT THE INVENTION

Hereinafter, embodiments of the invention will be described with reference to the drawings. Incidentally, in the following description, the same configurations as those in the background art described above are denoted by the same reference signs.

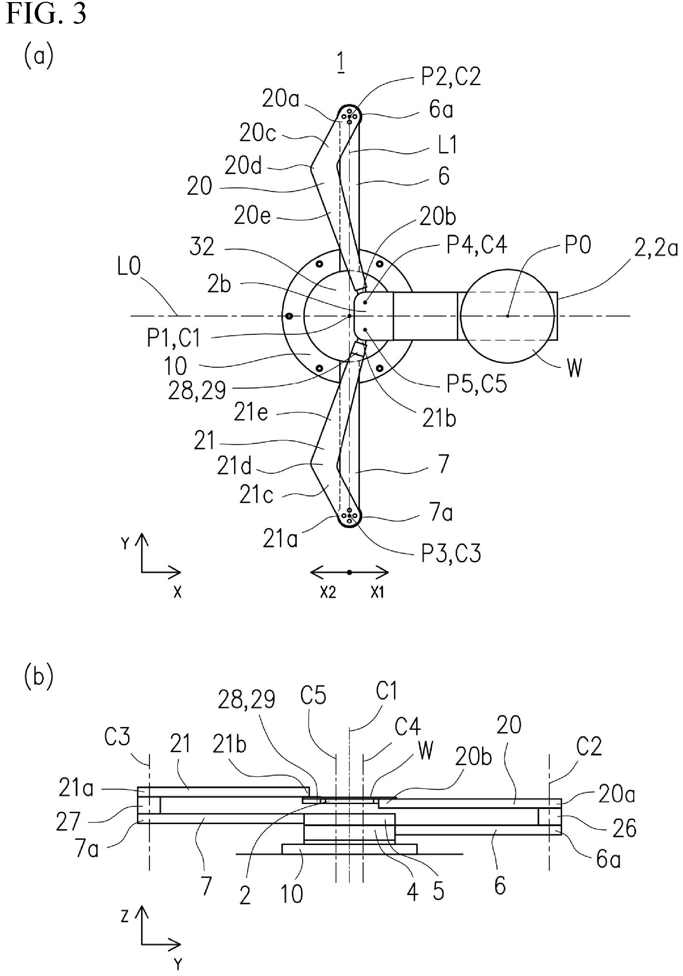

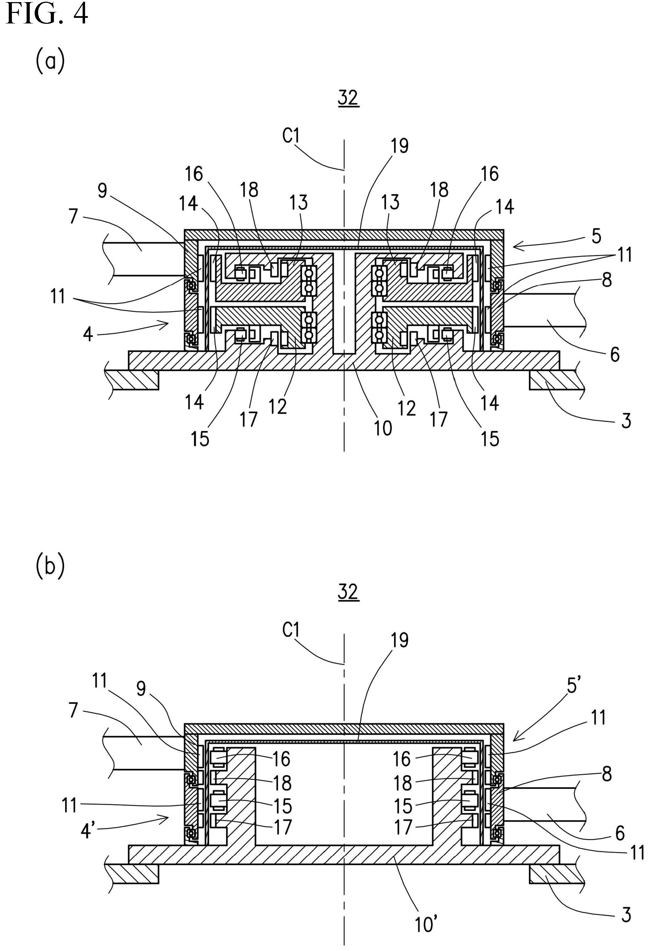

Fig. 3 is a view illustrating a handling robot 1, which is one embodiment of the invention, and Fig. 4(a) is a cross-sectional view illustrating a drive mechanism 32 of respective arms 6 and 7 provided in the handling robot 1. The handling robot 1 of the present embodiment is a so-called frog-leg arm robot. The drive mechanism 32 provided in the handling robot 1 of the present embodiment includes two direct drive motors 4 and 5 as drive sources, and the direct drive motors 4 and 5 are configured to individually rotate the first arm 6 and the second arm 7, respectively.

A first ring-shaped boss 8 and a second ring-shaped boss 9 are disposed concentrically about a rotation axis C1 passing through a center point P1 and extending in a vertical direction (Z direction), and are rotatably attached to a support base 10, which is provided in the transfer chamber 33, via bearings in a state in which the second ring-shaped boss 9 is stacked on the first ring-shaped boss 8. The first arm 6 is fixed to protrude from the first ring-shaped boss 8 in a radial direction centered on the rotation axis C1, and the second arm 7 is fixed to protrude from the second ring-shaped boss 9 in the radial direction centered on the rotation axis C1. In addition, the first arm 6 and the second arm 7 are disposed extending in a horizontal plane.

In addition, a plurality of permanent magnets 11 are disposed on each of the inner peripheral surfaces of the first and second ring-shaped bosses 8 and 9. A first rotor 12 and a second rotor 13 provided in the direct drive motors 4 and 5, respectively, are rotatably attached to the support base 10 via bearings inside the first and second ring-shaped bosses 8 and 9, respectively, in a state in which the first rotor 12 and the second rotor 13 are concentrically stacked so as to face the respective ring-shaped bosses. In addition, a plurality of permanent magnets 14 are fixed to a surface of each of the rotors 12 and 13, the surface being located on the outer peripheral surface side and facing the respective ring-shaped boss 8 or 9, such that the permanent magnets 14 have polarities opposite to those of the plurality of permanent magnets 11 disposed on each of the ring-shaped bosses 8 and 9. With the above-described configuration, the permanent magnets 11 disposed on the first and second ring-shaped bosses 8 and 9 and the permanent magnets 14 disposed on the first and second rotors 12 and 13 are magnetically coupled to each other. Accordingly, when each of the rotors 12 and 13 performs a rotational operation about the rotation axis C1 serving as the center of rotation due to the magnetic action of each of stators 15 and 16 to be described later, the first and second ring-shaped bosses 8 and 9 also perform a rotational operation, and further, the first arm 6 and the second arm 7 provided to protrude from the first and second ring-shaped bosses 8 and 9, respectively, also rotationally move about the rotation axis C1 serving as the center of rotation.

On the inner peripheral sides of the first and second rotors 12 and 13, the first and second stators 15 and 16 for causing the respective rotors 12 and 13 to perform a rotational operation are fixed to the support base 10 while being stacked concentrically about the rotation axis C1. A plurality of coils are disposed on each of the stators 15 and 16, and a magnetic field is generated by energizing the coils, thereby rotationally moving the respective rotors 12 and 13 facing the stators 15 and 16. With the above configuration, the first stator 15 and the first rotor 12 constitute the first direct drive motor 4, and the second stator 16 and the second rotor 13 constitute the second direct drive motor 5. In addition, the first and second direct drive motors 4 and 5 are electrically connected to a control unit (not illustrated), and the control unit causes the first and second rotors 12 and 13 to perform a rotational operation in a predetermined rotation direction at a predetermined rotation speed by transmitting predetermined operation signals.

In addition, the first direct drive motor 4 and the second direct drive motor 5 are provided with position detectors 17 and 18, respectively, that detect the rotation positions of the first rotor 12 and the second rotor 13. In addition, a partition wall 19 having a cylindrical shape and an airtightly closed upper portion is disposed between the first direct drive motor 4 and the first ring-shaped boss 8 and between the second direct drive motor 5 and the second ring-shaped boss 9. The partition wall 19 airtightly isolates an atmospheric pressure environment in which the first and second direct drive motors 4 and 5 are disposed from a vacuum pressure environment in which the first and second ring-shaped bosses 8 and 9 and the first and second arms 6 and 7 are disposed.

In addition, instead of the direct drive motors 4 and 5 illustrated in Fig. 4(a), as illustrated in Fig. 4(b), direct drive motors 4' and 5' that are configured such that the first stator 15 directly rotates the first ring-shaped boss 8 located to face the first stator 15 with the partition wall 19 interposed therebetween and the second stator 16 directly rotates the second ring-shaped boss 9 located to face the second stator 16 with the partition wall 19 interposed therebetween may be employed. In the direct drive motor 4', a magnetic field generated by the first stator 15 acts on the plurality of permanent magnets 11, which are provided on the first ring-shaped boss 8, to rotate the first ring-shaped boss 8, and in the direct drive motor 5', a magnetic field generated by the second stator 16 acts on the plurality of permanent magnets 11, which are provided on the second ring-shaped boss 9, to rotate the second ring-shaped boss 9. In addition, the rotation position of the first ring-shaped boss 8 of the direct drive motor 4' is detected by the first position detector 17, and the rotation position of the second ring-shaped boss 9 of the direct drive motor 5' is detected by the second position detector 18. Each of the first stator 15, the second stator 16, the first position detector 17, and the second position detector 18 is fixed to a support base 10' formed in a substantially cylindrical shape.

Next, the first arm 6, the second arm 7, a first link 20, a second link 21, and the holding finger 2 provided in the handling robot 1 of the present embodiment will be described. Incidentally, in the following description and the drawings to be referred to, the vertical direction is defined as the Z direction, a direction orthogonal to the Z direction and corresponding to the advancing and retracting direction of the holding finger 2 is defined as an X direction, and a direction orthogonal to the X direction in a horizontal plane is defined as a Y direction.

A proximal end portion 20a of the first link 20 is connected to a distal end portion 6a of the first arm 6, the proximal end of which is fixed to the first ring-shaped boss 8, via a bearing so as to be rotatable about a rotation axis C2 serving as the center of rotation, passing through a center point P2, and extending in the vertical direction (Z direction). In addition, a proximal end portion 21a of the second link 21 is connected to a distal end portion 7a of the second arm 7, the proximal end of which is fixed to the second ring-shaped boss 9, via a bearing so as to be rotatable about a rotation axis C3 serving as the center of rotation, passing through a center point P3, and extending in the vertical direction (Z direction). A distal end portion 20b of the first link 20 is connected to a base portion 2b of the first holding finger 2 via a bearing so as to rotatable about a rotation axis C4 serving as the center of rotation, passing through a center point P4, and extending in the vertical direction (Z direction), and a distal end portion 21b of the second link 21 is connected to the base portion 2b of the first holding finger 2 via a bearing so as to be rotatable about a rotation axis C5 serving as the center of rotation, passing through a center point P5, and extending in the vertical direction (Z direction). Accordingly, when the first arm 6 and the second arm 7 perform a rotational operation in opposite directions, the first link 20 and the second link 21 perform a rotational operation in opposite directions. In more detail, the first link 20 and the second link 21 perform a rotational operation so as to be symmetrical to each other with respect to a straight line L0 connecting the center point P1 and a center point P0 of the workpiece W held by a workpiece holding portion 2a of the holding finger 2, and extending in the X direction in plan view.

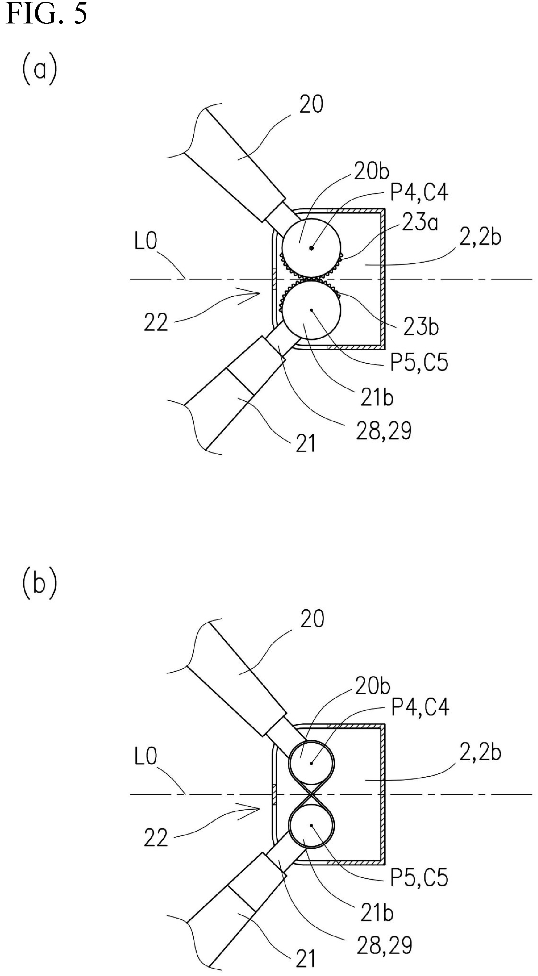

The respective distal end portions 20b and 21b of the first link 20 and the second link 21 are connected to each other via a posture regulating mechanism 22. Fig. 5(a) is a cross-sectional view illustrating the posture regulating mechanism 22 provided in the handling robot 1 of the present embodiment. Teeth 23a and 23b are fixed to the respective distal end portions 20b and 21b of the first and second links 20 and 21 connected to the base portion 2b of the holding finger 2, so as to mesh with each other. The posture regulating mechanism 22 causes an angle formed between the first link 20 and the straight line L0 and an angle formed between the second link 21 and the straight line L0 to become equal, even when the first link 20 and the second link 21 perform a rotational operation in a horizontal plane, so that the holding finger 2 is regulated to be always oriented in the radial direction centered on the rotation axis C1. Incidentally, the connection between the first link 20 and the second link 21 may be performed by fixing disk-shaped pulleys to the respective distal end portions 20b and 21b and crossing a belt between the pulleys as illustrated in Fig. 5(b), instead of the teeth 23a and 23b meshing with each other, thereby regulating the posture of the holding finger 2.

With the above-described configuration, the handling robot 1 of the present embodiment is configured such that, when the first direct drive motor 4 and the second direct drive motor 5 perform a rotational operation at the same rotation speed in opposite directions, the first arm 6 and the first link 20, and the second arm 7 and the second link 21 perform a bending and extending operation to move the holding finger 2 forward and backward in the X direction. In addition, when the first direct drive motor 4 and the second direct drive motor 5 rotationally move at the same rotation speed in the same direction, the handling robot 1 performs a turning operation about the rotation axis C1 serving as the center of rotation. Here, the rotation axis C1 is the common center of rotation for the first arm 6 and the second arm 7, and is also the robot turning axis C1 for the handling robot 1. With the above-described configuration, when the handling robot 1 is installed in the transfer chamber 33, by performing a turning operation about the robot turning axis C1 serving as the center of rotation, the handling robot 1 is capable of being oriented toward a predetermined process chamber 24 or the load lock station 25 provided adjacent to the periphery of the transfer chamber 33, and is capable of advancing and retracting the holding finger 2 in the radial direction centered on the rotation axis C1 relative to the predetermined process chamber 24 or the load lock station 25.

Incidentally, in addition to the above-described configuration, the handling robot 1 of the present embodiment may also be provided with a lifting mechanism (not illustrated) that moves the first and second direct drive motors 4 and 5 upward and downward in the vertical direction. Since the handling robot 1 is provided with the lifting mechanism, the handling robot 1 is capable of transferring the workpiece W between a workpiece placement table, which is provided in the process chamber 24 or the load lock station 25, and the holding finger 2 by moving itself upward and downward relative to the workpiece placement table.

Incidentally, the first arm 6 and the second arm 7 are disposed at different height positions in the vertical direction, and even when the first arm 6 and the second arm 7 perform a rotational operation in opposite directions, the first arm 6 and the second arm 7 do not collide with each other, and can continue to perform a rotational operation.

In addition, the first link 20 is attached to the distal end portion 6a of the first arm 6 via a spacer 26 such that the first link 20 is located in a space positioned above the space in which the second direct drive motor 5 is disposed, and the second link 21 is attached to the distal end portion 7a of the second arm 7 via a spacer 27 such that the second link 21 is located in a space positioned above the space in which the first link 20 is disposed.

With the above-described configuration, the handling robot 1 of the present embodiment has a structure in which the first arm 6, the second arm 7, the first link 20, and the second link 21 are disposed at different height levels in four spaces partitioned in the vertical direction. The first arm 6 driven by the first direct drive motor 4 is disposed in a first space, which is the lowermost layer, the second arm 7 driven by the second direct drive motor 5 is disposed in a second space thereabove, the first link 20 is disposed in a third space thereabove, and the second link 21 is disposed in a fourth space, which is the uppermost layer.

The holding finger 2 is a thin plate-shaped member, and is composed of the workpiece holding portion 2a for holding the workpiece W and the base portion 2b for connection to the first and second links 20 and 21. Incidentally, since the first link 20 and the second link 21 are disposed at heights different from each other in the vertical direction, the height of each of the distal end portions 20b and 21b needs to be adjusted. Therefore, in the handling robot 1 of the present embodiment, a bracket 29 for eliminating a step 28 is attached such that the distal end portion 21b of the second link 21 is at the same height as the distal end portion 20b of the first link 20, and the distal end portion 21b of the second link 21 is adjusted by the bracket 29 so as to be at the same height as the distal end portion 20b of the first link 20.

Incidentally, as another embodiment, a bracket (not illustrated) for eliminating a step may be provided at the distal end portion 20b of the first link 20 disposed at a lower position, and the distal end portion 20b of the first link 20 is adjusted so as to be at the same height as the distal end portion 21b of the second link 21. Furthermore, the height position of the holding finger 2 may be adjusted by a bracket (not illustrated) so as to be intermediate between the first link 20 and the second link 21.

Fig. 3(a) is a plan view illustrating the posture of the handling robot 1 when the first arm 6 and the second arm 7 are at an origin position. When the first arm 6 and the second arm 7 are at the original position, an angle formed between the first arm 6 and the second arm 7 is 180 degrees in plan view, and the first arm 6 and the second arm 7 are located on a straight line. In more detail, in plan view, the rotation axis C2 set at the distal end portion 6a of the first arm 6 and the rotation axis C3 set at the distal end portion 7a of the second arm 7 coincide with a straight line L1 passing through the common rotation axis C1 of the first and second arms 6 and 7 and extending in the Y direction. As illustrated in Fig. 3(a), at the origin position, the center points P4 and P5 of the holding finger 2, to which the distal end portions of the links 20 and 21 are connected, are slightly offset from the straight line L1 toward the traveling direction of the holding finger 2.

From this state, the handling robot 1 moves the holding finger 2 forward in an X1 direction by rotating the first arm 6 clockwise about the rotation axis C1 serving as the center of rotation in plan view and rotating the second arm 7 counterclockwise about the rotation axis C1 serving as the center of rotation in plan view. In addition, the handling robot 1 moves the holding finger 2 backward in an X2 direction by rotating the first arm 6 counterclockwise about the rotation axis C1 serving as the center of rotation and rotating the second arm 7 clockwise about the rotation axis C1 serving as the center of rotation.

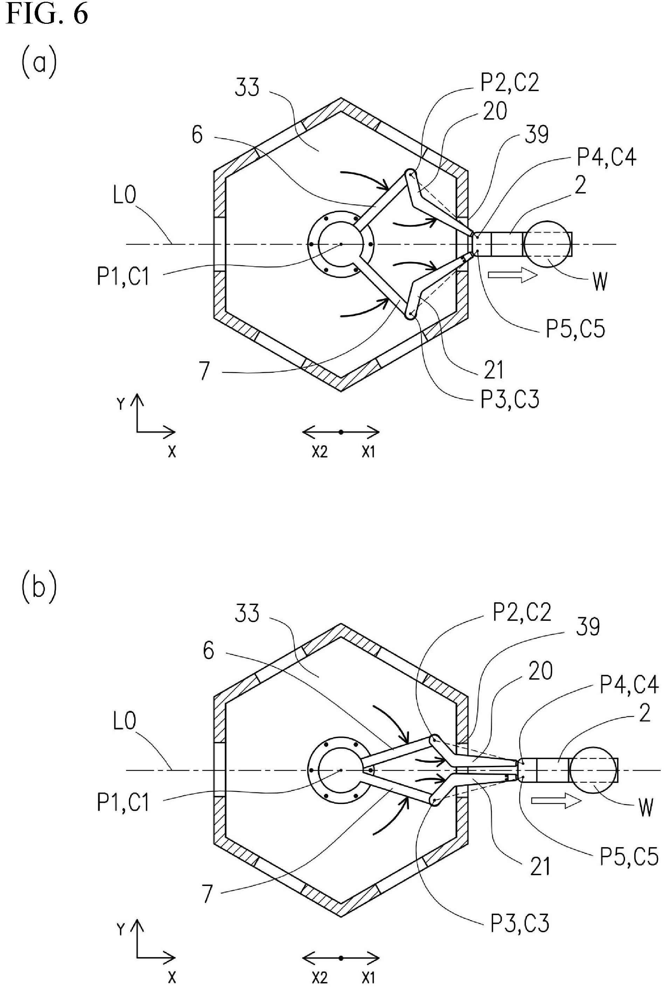

Here, referring to Fig. 3(a), each of the first link 20 and the second link 21 provided in the handling robot 1 has a shape including a portion curved in a direction opposite to the advancing direction (the X1 direction) of the holding finger 2 (in the X2 direction) in plan view. To explain further, as illustrated in Figs. 6(a) and 6(b), when moving the holding finger 2 forward in the advancing direction (X1 direction), the first link 20 performs a counterclockwise rotational operation in a horizontal plane about the rotation axis C2 serving as the center of rotation, and the first link 20 has a shape including a portion curved in a clockwise direction, which is the direction opposite to a counterclockwise rotation direction for advancing the holding finger 2. In addition, when the second link 21 moves the holding finger 2 forward in the advancing direction (X1 direction), the second link 21 rotationally moves clockwise in a horizontal plane about the rotation axis C3 serving as the center of rotation, and the second link 21 has a shape including a portion curved in a counterclockwise direction, which is the direction opposite to a clockwise rotation direction for advancing the holding finger 2.

The curved portions of the first link 20 and the second link 21 will be described with reference to Fig. 3(a). In the following description, in the present specification, the rotation of the first link 20 in the counterclockwise direction and the rotation of the second link 21 in the clockwise direction for advancing the holding finger 2 is defined as "forward rotation", and the clockwise rotation of the first link 20 and the counterclockwise rotation of the second link 21 for retracting the holding finger 2 is defined as "reverse rotation". Each of the first link 20 and the second link 21 has a portion curved in a direction opposite to a forward rotation direction in plan view. The first link 20 has a portion 20c extending from the proximal end portion 20a in the direction opposite to the forward rotation direction in a horizontal plane, and further has a portion 20e extending in the forward rotation direction toward the distal end portion 20b with a predetermined bending point 20d as a boundary, and the distal end portion 20b is connected to the holding finger 2. Similarly, the second link 21 has a portion 21c extending from the proximal end portion 21a in the direction opposite to the forward rotation direction in a horizontal plane, and has a portion 21e extending in the forward rotation direction toward the distal end portion 21b with a predetermined bending point 21d as a boundary, and the distal end portion 21b is connected to the holding finger 2. With the above-described configuration, the first link 20 and the second link 21 are capable of passing even through the gate 39 having a small lateral width dimension, through which the conventional links 42 and 43 having a linear shape cannot pass, so that the workpiece W can be safely transported. Incidentally, the first link 20 and the second link 21 of the present embodiment have shapes symmetrical to each other with respect to the straight line L0 in plan view; however, the invention is not limited to this configuration, and the first link 20 and the second link 21 may have asymmetrical shapes.

It is preferable that the bending points 20d and 21d are located closer to the rotation axes C2 and C3 than to central portions of the first link 20 and the second link 21; for example, it is preferable that the bending points 20d and 21d are located at positions approximately one-quarter of the length of the first link 20 and the second link 21 from the rotation axes C2 and C3 or are located closer thereto than the positions. In addition, the portions 20c and 21c extending toward the bending points 20d and 21d and the portions 20e and 21e extending toward the distal end portion 20b and 21b may have a linear shape, but may be partly or entirely formed in a gently curved shape in accordance with the rotation of the first link 20 and the second link 21 and the gate 39 (see Fig. 6 and the like) through which the first link 20 and the second link 21 pass.

Fig. 6(a) is a view illustrating an operation in which the handling robot 1 moves the workpiece W, which is held by the holding finger 2, in the X1 direction through the gate 39. At this time, as the first arm 6 and the second arm 7 perform a rotational operation in directions approaching each other in plan view, the first link 20 and the second link 21 also rotate forward in a horizontal plane in directions approaching each other. Here, unlike the conventional links 42 and 43 having a linear shape, since the first link 20 and the second link 21 have shapes curved in directions approaching each other, the lateral width dimension of the first link 20 and the second link 21 can be reduced as compared with the lateral width dimension of the conventional links 42 and 43 having a linear shape. Accordingly, the lateral width dimension of the gate 39 can be reduced as compared with that of the conventional gate.

Furthermore, in the handling robot 1 of the present embodiment, since the spaces in a height direction in which the first link 20 and the second link 21 are disposed do not overlap each other, the first link 20 and the second link 21 do not collide with each other even when rotating forward in directions approaching each other, so that the operating range of the first link 20 and the second link 21 can be significantly increased. For example, when the spaces in the height direction occupied by the first link 20 and the second link 21 overlap each other, the positions of the first link 20 and the second link 21 as illustrated in Fig. 6(b), which are obtained when the first link 20 and the second link 21 rotate forward, represent the limits of a range in which the handling robot 1 is capable of transporting the workpiece W.

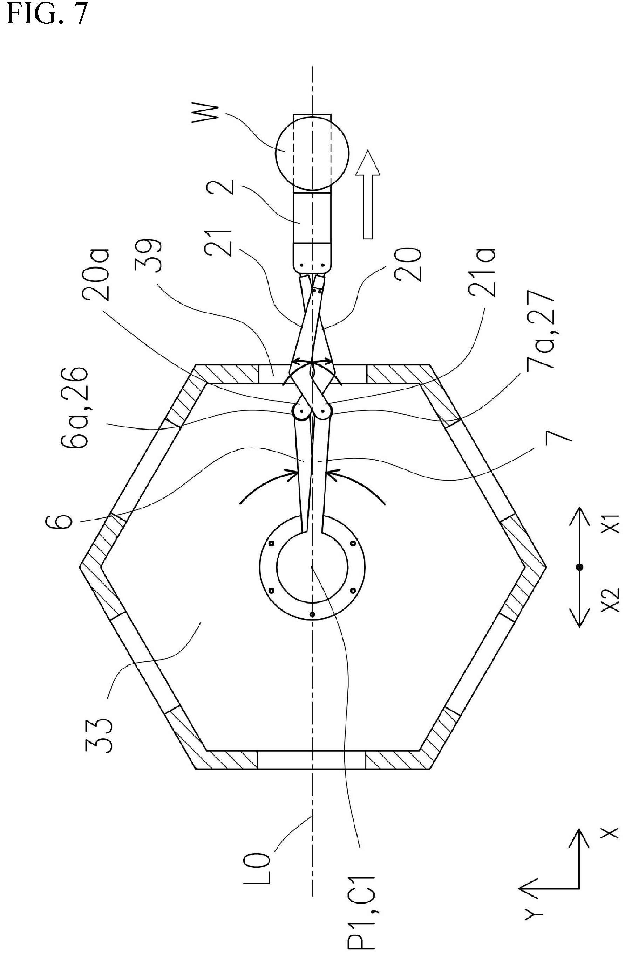

In contrast, since the spaces in the height direction in which the first link 20 and the second link 21 are disposed do not overlap each other, the first link 20 and the second link 21 are still capable of performing a forward rotation operation without colliding with each other even at the positions illustrated in Fig. 6(b), so that the holding finger 2 is allowed to reach a more distant position (see Fig. 7). In the handling robot 1 of the present embodiment, the operations of the first arm 6 and the second arm 7 can be continued until the spacer 27 disposed at the distal end portion 7a of the second arm 7 comes into contact with the proximal end portion 20a of the first link 20, or until the spacer 26 disposed at the distal end portion 6a of the first arm 6 comes into contact with the proximal end portion 21a of the second link 21 (see Fig. 7).

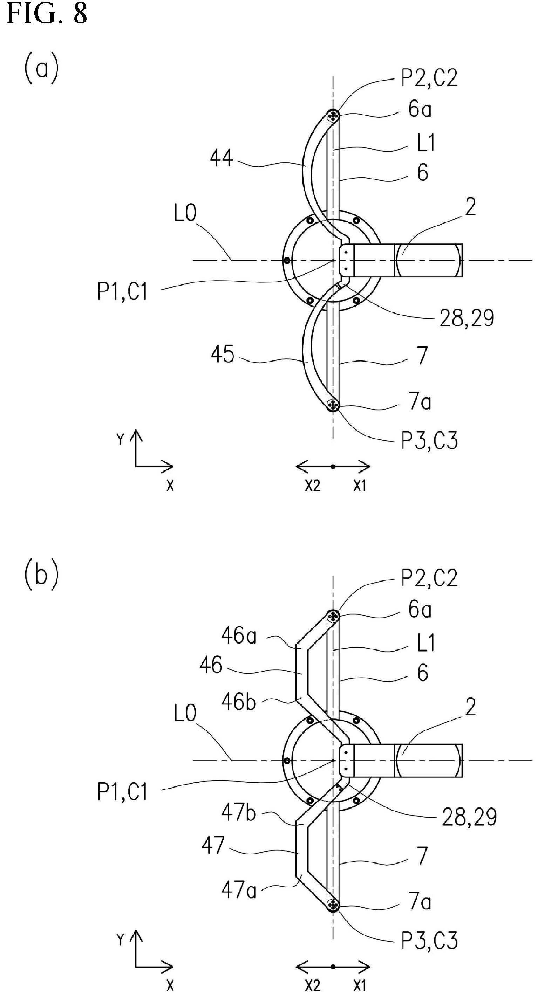

Incidentally, each of the first link 20 and the second link 21 of the present embodiment has been described as including a curved portion in a horizontal plane; however, the curved state is not limited to the above-described embodiment, and embodiments to be described below are also included in the curved state. For example, the same effects can also be obtained in an embodiment in which a first link 44 and a second link 45 are formed in an arc shape toward the direction opposite to the forward rotation direction as illustrated in Fig. 8(a), and further, the same effects can also be obtained in an embodiment in which each of first and second links 46 and 47 includes three or more linear portions and two or more bending points connecting the linear portions as illustrated in Fig. 8(b).

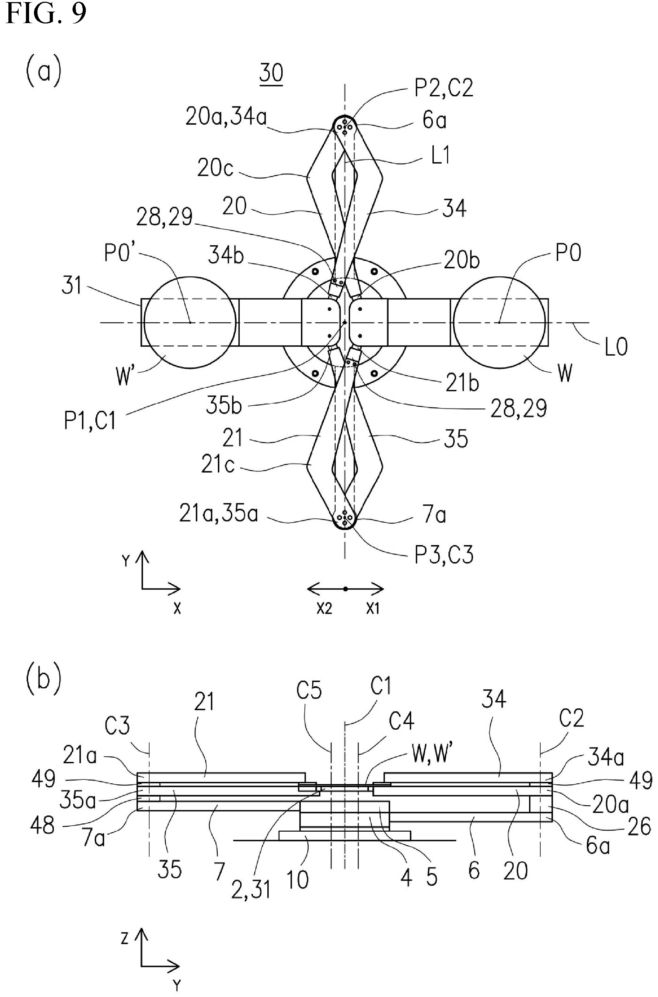

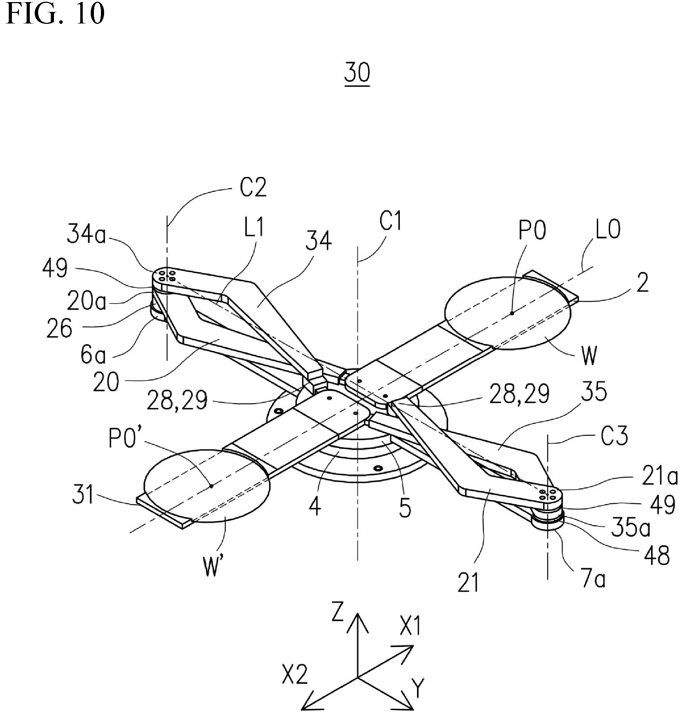

Next, a handling robot 30, which is a second embodiment of the invention, will be described. Fig. 9(a) is a plan view illustrating a state in which the handling robot 30 is at an origin position, and Fig. 9(b) is a front view of the handling robot 30. In addition, Fig. 10 is a perspective view illustrating a state in which the handling robot 30 is at the origin position. The handling robot 30 includes a second holding finger 31 and a third link 34 and a fourth link 35, which move the second holding finger 31 forward and backward, in addition to the configuration of the handling robot 1, which is the first embodiment. In addition, similarly to the first link 20 and the second link 21, a distal end portion 34b of the third link 34 and a distal end portion 35b of the fourth link 35 are connected to the second holding finger 31 via a known posture regulating mechanism. Here, the center point P0 of the workpiece W held by the first holding finger 2 and a center point P0' of a workpiece W' held by the second holding finger 31 are located on the straight line L0 passing through the rotation axis C1 and extending in the X1 direction in plan view. Since the second handling robot 30 includes the second holding finger 31, the third link 34, and the fourth link 35 in addition to the configuration of the first handling robot 1, the second handling robot 30 is capable of holding and transporting two workpieces W and W' at the same time.

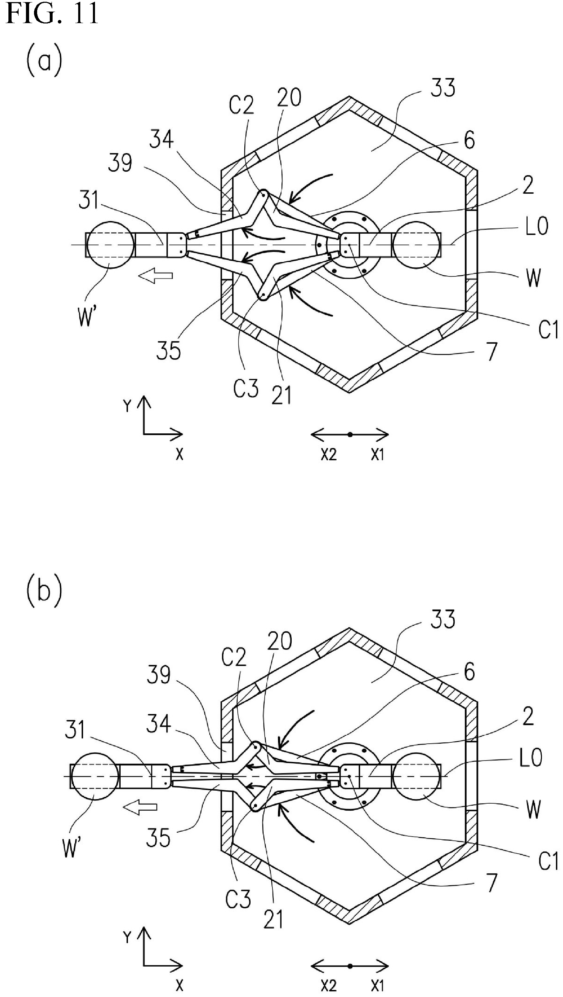

In addition, when the handling robot 30 of the present embodiment is at the origin position, in plan view, the third link 34 and the fourth link 35 have shapes symmetrical to each other with respect to the straight line L1, which passes through the rotation axis C1 and extends in the Y direction, relative to the first link 20 and the second link 21. In addition, the third link 34 and the fourth link 35 have shapes symmetrical to each other with respect to the straight line L0 passing through the rotation axis C1 and extending in the X direction in plan view. Furthermore, each of the third link 34 and the fourth link 35 has a shape including a portion curved in a direction opposite to the advancing direction (X2 direction) of the second holding finger 31 (in the X1 direction) in plan view. To explain further, as illustrated in Figs. 11(a) and 11(b), the third link 34 rotationally moves clockwise (rotates forward) in a horizontal plane about the rotation axis C2 serving as the center of rotation to move the second holding finger 31 forward in the advancing direction (X2 direction), and the third link 34 has a portion curved in the counterclockwise direction, which is the direction opposite to the clockwise rotation direction (forward rotation direction) for advancing the second holding finger 31. In addition, the fourth link 35 rotationally moves counterclockwise (rotates forward) in a horizontal plane about the rotation axis C3 serving as the center of rotation to move the second holding finger 31 forward in the advancing direction (X2 direction), and the fourth link 35 has a portion curved in the clockwise direction, which is the direction opposite to the counterclockwise rotation direction (forward rotation direction) for advancing the second holding finger 31.

In the handling robot 30 of the present embodiment, the proximal end portion 20a of the first link 20 is connected to the distal end portion 6a of the first arm 6 so as to be rotatable in a horizontal plane about the rotation axis C2 serving as the center of rotation, and a proximal end portion 34a of the third link 34 is connected above the proximal end portion 20a of the first link 20 so as to be rotatable in a horizontal plane about the rotation axis C2 serving as the center of rotation. In addition, a proximal end portion 35a of the fourth link 35 is connected to the distal end portion 7a of the second arm 7 so as to be rotatable in a horizontal plane about the rotation axis C3 serving as the center of rotation, and the proximal end portion 21a of the second link 21 is connected above the proximal end portion 35a of the fourth link 35 so as to be rotatable in a horizontal plane about the rotation axis C3 serving as the center of rotation. The spacer 26 is disposed between the distal end portion 6a of the first arm 6 and the proximal end portion 20a of the first link 20, and a spacer 48 is disposed between the distal end portion 7a of the second arm 7 and the proximal end portion 35a of the fourth link 35. The first link 20 and the fourth link 35 are adjusted by the spacers 26 and 48 so as to be at the same height position in the vertical direction. In addition, a spacer 49 for adjusting a position in the height direction is disposed between the proximal end portion 20a of the first link 20 and the proximal end portion 34a of the third link 34, and similarly, a spacer 49 for adjusting a position in the height direction is also disposed between the proximal end portion of the fourth link 35 and the proximal end portion of the second link 21. The third link 34 and the second link 21 are adjusted by the spacers 49 so as to be at the same height position in the vertical direction.

In the handling robot 30 of the present embodiment, the first link 20 and the second link 21, which move the first holding finger 2 forward and backward, are disposed at height positions different from each other, and the third link 34 and the fourth link 35, which move the second holding finger 31 forward and backward, are disposed at height positions different from each other.

The handling robot 30 of the present embodiment is configured such that the first arm 6, the second arm 7, the first link 20, the second link 21, the third link 34, and the fourth link 35 are disposed in four spaces partitioned in an up-down direction. The first arm 6 driven by the first direct drive motor is disposed in a first space, which is the lowermost layer, and the second arm 7 driven by the second direct drive motor is disposed in a second space thereabove. The first link 20 and the fourth link 35 are disposed in a third space thereabove, and the second link 21 and the third link 34 are disposed in a fourth space, which is the uppermost level. In addition, the first link 20 and the third link 34, and the second link 21 and the fourth link 35 are disposed so as to be symmetrical to each other with respect to the straight line L1 in plan view. Furthermore, the first link 20 and the third link 34, and the second link 21 and the fourth link 35 are disposed in spaces at different height positions. As described above, the handling robot 30 of the present embodiment is configured such that the third link 34 and the fourth link 35 are added to the handling robot 1 of the first embodiment; however, since the third link 34 is disposed in the same space as that in which the second link 21 is disposed, and the fourth link 35 is disposed in the same space as that in which the first link 20 is disposed, the dimension of the handling robot 30 in the height direction can be suppressed to be the same as that of the handling robot 1 of the first embodiment.

Next, a forward rotation operation in which the third link 34 and the fourth link 35 advance the second holding finger 31 in conjunction with the rotational operations of the first arm 6 and the second arm 7 will be described. When the first arm 6 and the second arm 7 are at the original position, an angle formed between the first arm 6 and the second arm 7 is 180 degrees in plan view, and the first arm 6 and the second arm 7 are located on a common straight line. In this state, the common rotation axis C1 of the first and second direct drive motors 4 and 5, the common rotation axis C2 of the first link 20 and the third link 34, and the common rotation axis C3 of the second link 21 and the fourth link 35 are located on the straight line L1 extending in the Y direction in plan view. In addition, the first holding finger 2 and the second holding finger 31 are disposed so as to be symmetrical to each other with respect to the straight line L1 in plan view.

Here, by rotating the first arm 6 counterclockwise about the rotation axis C1 serving as the center of rotation in plan view and rotating the second arm 7 clockwise about the rotation axis C1 serving as the center of rotation in plan view, the third link 34 and the fourth link 35 rotate forward to move the second holding finger 31 in the X2 direction (see Fig. 11(a)). At this time, the first link 20, which is connected to the first arm 6 together with the third link 34, rotates counterclockwise (rotates in reverse) about the rotation axis C2 serving as the center of rotation, and the second link 21, which is connected to the second arm 7 together with the fourth link 35, rotates clockwise (rotates in reverse) about the rotation axis C3 serving as the center of rotation.

As the operation of the first arm 6 and the operation of the second arm 7 continue, the first arm 6 and the second arm 7 move in directions approaching each other in plan view. Along with this operation, the first link 20 and the second link 21 move in directions approaching each other in plan view, and the third link 34 and the fourth link 35 also move in directions approaching each other in plan view. Here, when the first link 20 and the second link 21, and the third link 34 and the fourth link 35 are disposed in the spaces that are at the same level in the vertical direction, at the position illustrated in Fig. 11(b), the respective curved portions of the first link 20 and the second link 21 come into contact with each other, and the respective curved portions of the third link 34 and the fourth link 35 come into contact with each other. Therefore, the positions of the first link 20 and the second link 21 and the positions of the third link 34 and the fourth link 35 as illustrated in Fig. 11(b) represent the limits of a range in which the handling robot 30 is capable of transporting the workpieces W and W'.

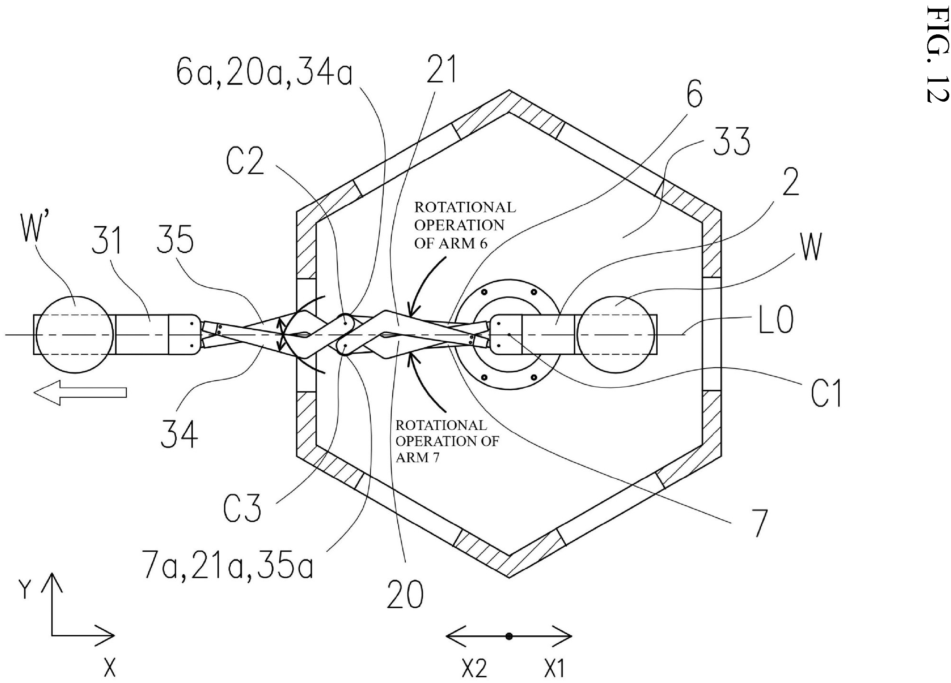

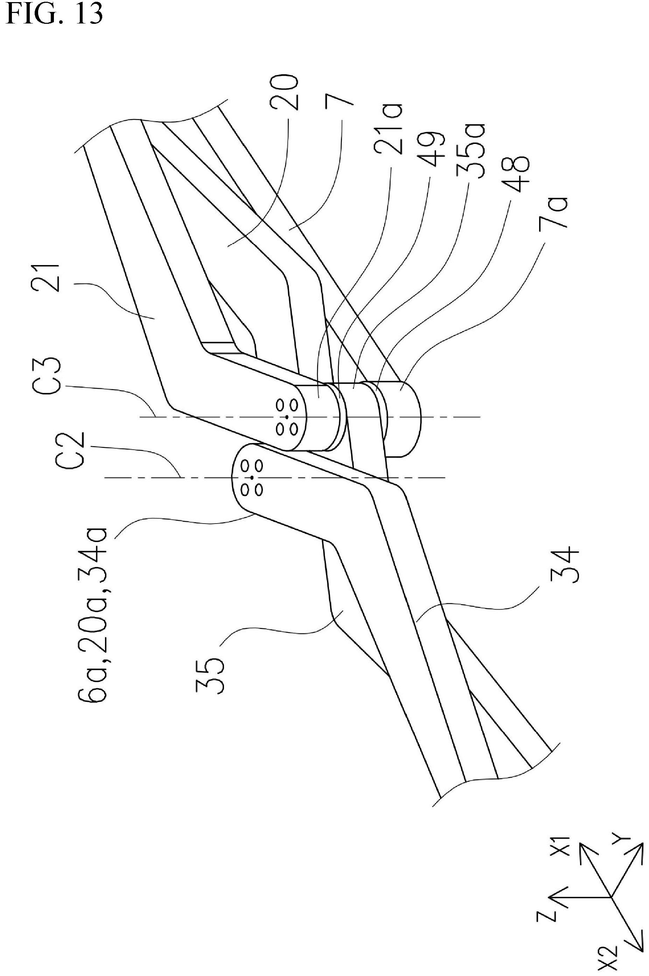

Since the first link 20 and the second link 21, and the third link 34 and the fourth link 35 provided in the handling robot 30 of the present embodiment are disposed in spaces different from each other in the vertical direction, the first link 20, the second link 21, the third link 34, and the fourth link 35 are still capable of operating without colliding with each other even at the position illustrated in Fig. 11(b), so that the holding finger 31 is allowed to reach a more distant position (see Fig. 12). In the handling robot 30 of the present embodiment, similarly to the first embodiment, the operations of the first arm 6 and the second arm 7 can be continued until just before the distal end portion 7a of the second arm 7 comes into contact with the proximal end portion 20a of the first link 20, or until just before the distal end portion 6a of the first arm 6 comes into contact with the proximal end portion 35a of the fourth link 35 (see Fig. 13).

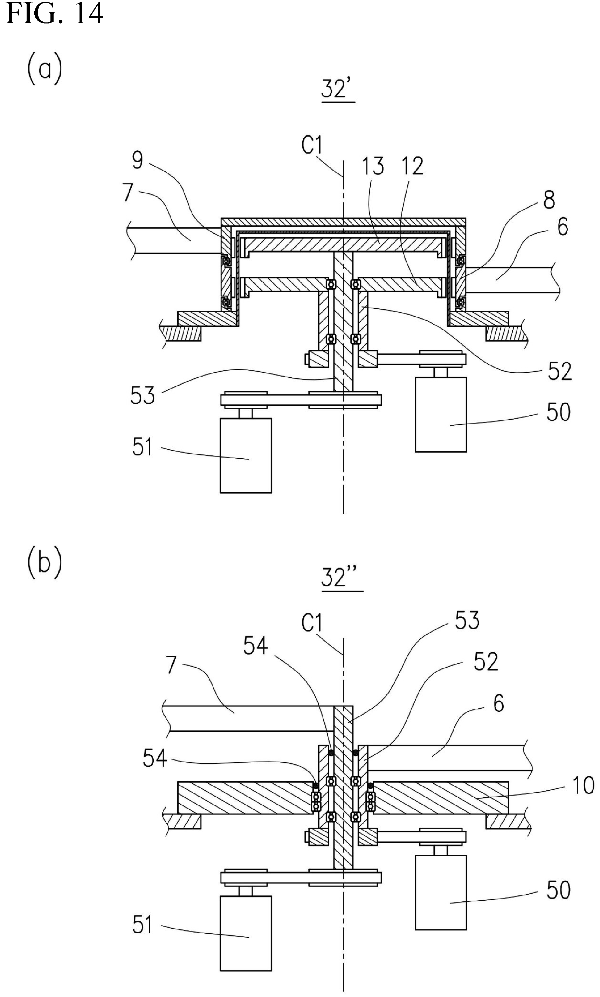

Here, each of the handling robot 1 of the first embodiment and the handling robot 30 of the second embodiment includes the two direct drive motors 4 and 5 as the drive sources of the drive mechanism 32; however, the invention is not limited to this configuration, and various drive mechanisms 32' and 32" described below can be applied. Fig. 14(a) illustrates the drive mechanism 32' that drives the respective rotors 12 and 13 using motors 50 and 51, respectively, which are known drive sources. In this embodiment, the first rotor 12 and a hollow drive shaft 52, which are disposed coaxially with respect to the rotation axis C1, are configured to be rotationally driven by the first stepping motor 50 connected thereto via a belt and a pulley, and the second rotor 13 and a solid drive shaft 53, which are disposed coaxially with respect to the rotation axis C1, are configured to be rotationally driven by the second stepping motor 51 connected thereto via a belt and a pulley. The hollow drive shaft 52 and the solid drive shaft 53 are disposed coaxially with respect to the rotation axis C1. With the above-described configuration, the first rotor 12, the first ring-shaped boss 8, and the first arm 6 can be rotated about the rotation axis C1 serving as the center of rotation through a predetermined rotation angle by actuating the first stepping motor 50, and the second rotor 13, the second ring-shaped boss 9, and the second arm 7 can be rotated about the rotation axis C1 serving as the center of rotation through a predetermined rotation angle by actuating the second stepping motor 51.

Fig. 14(b) is a view illustrating a drive mechanism in which the first arm 6 and the second arm 7 are directly fixed to the hollow drive shaft 52 and the solid drive shaft 53, respectively, without providing the rotors 12 and 13 or the ring-shaped bosses 8 and 9. Incidentally, in the drive mechanism 32", it is desirable that seal members 54 that isolate an atmospheric pressure environment in which the stepping motors 50 and 51 or pulleys are disposed from a vacuum pressure environment in which the first arm 6 or the second arm 7 is disposed are provided between the hollow drive shaft 52 and the solid drive shaft 53 and between the hollow drive shaft 52 and the support base 10.

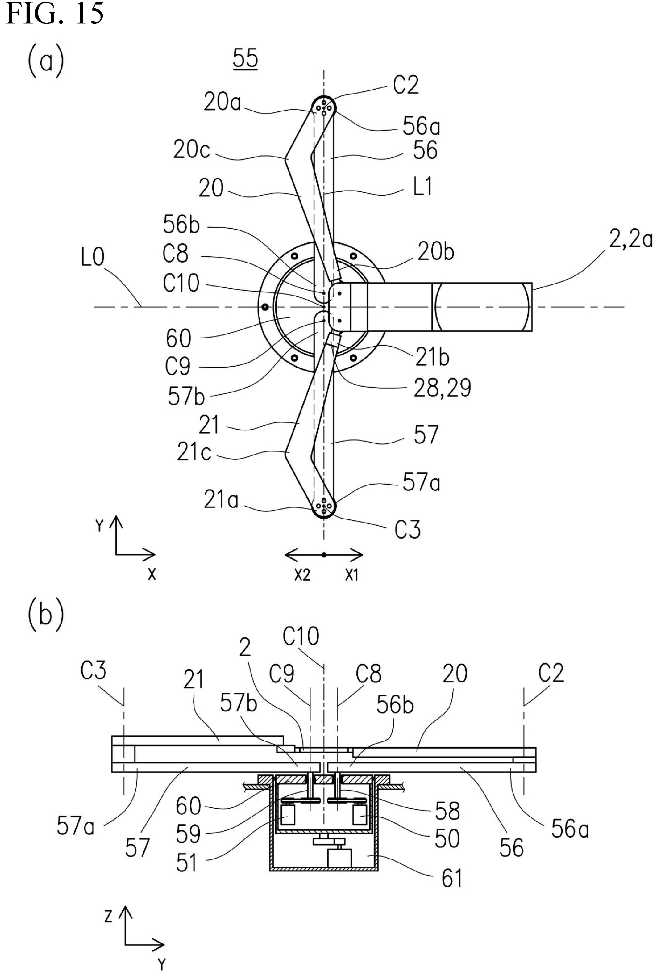

As described above, in both the handling robot 1 of the first embodiment and the handling robot 30 of the second embodiment, the first arm 6 and the second arm 7 are configured to perform a rotational operation in opposite directions about the common rotation axis C1 serving as the center of rotation to move the first holding finger 2 and the second holding finger 31 forward and backward, and the first arm 6 and the second arm 7 are configured to perform a rotational operation in the same direction about the rotation axis C1 serving as the center of rotation to cause the handling robots 1 and 30 to perform a turning operation about the rotation axis C1 serving as the center of rotation. In other words, the rotation axis C1 is the common center axis of rotation for the rotational operations of the first arm 6 and the second arm 7, and is also the center axis of turning for the turning operations of the handling robots 1 and 30. The invention is not limited to this configuration, and an embodiment in which a first arm 56 and a second arm 57 are rotated about separate rotation axes C8 and C9, respectively, that serve as the centers of rotation and are parallel to each other can also be employed. Fig. 15(a) is a plan view illustrating a handling robot 55 including the rotation axis C8 of the first arm 6 and the rotation axis C9 of the second arm 7, and Fig. 15(b) is a cross-sectional view of the handling robot 55.

In the handling robot 55 of the present embodiment, a first drive shaft 58 is attached to a proximal end portion 56b of the first arm 56 so as to stand up in the vertical direction, and a second drive shaft 59 is attached to a proximal end portion 57b of the second arm 57 so as to stand up in the vertical direction. The first drive shaft 58 is supported on a base plate 60 via a bearing so as to be rotatable about the rotation axis C8 serving as the center of rotation and extending in the vertical direction, and the second drive shaft 59 is supported on the base plate 60 via a bearing so as to be rotatable about the rotation axis C9 serving as the center of rotation and extending in the vertical direction. The first shaft 58 and the second shaft 59 are connected to the output shafts of the stepping motors 50 and 51 via pulleys and belts, respectively, and the stepping motors 50 and 51 are individually actuated to cause the first arm 56 and the second arm 57 to individually perform a rotational operation.

Furthermore, the handling robot 55 of the present embodiment includes a base plate drive mechanism 61 that rotates the base plate 60 in a horizontal plane about a rotation axis C10 serving as the center of rotation. In addition, the rotation axis C8 and the rotation axis C9 are located on the straight line L1 passing through the rotation axis C10 and extending in the Y direction in plan view. The configurations of the first and second links 20 and 21 connected to respective distal end portions 56a and 57a of the first arm 56 and the second arm 57, and the configuration of the first holding finger 2 is the same as that of the first holding finger 2 provided in the handling robot 1 of the first embodiment described above. That is, the first link 20 and the second link 21 provided in the handling robot 55 have a shape curved in a direction opposite to a forward rotation direction, and the distal end portions of the first link 20 and the second link 21 are connected to the first holding finger 2 via a known posture regulating mechanism. With this configuration, when the first arm 56 rotates clockwise (rotates forward) in plan view and the second arm 57 rotates counterclockwise (rotates forward), the first holding finger 2 moves forward in the X1 direction, and when the first arm 56 rotates counterclockwise (rotates in reverse) in plan view and the second arm 57 rotates clockwise (rotates in reverse), the first holding finger 2 moves backward in the X2 direction.

With the above-described configuration, by performing a turning operation about the rotation axis C10 serving as the center of rotation, the handling robot 55 can be oriented toward the front faces of the process chambers 24 or the load lock stations disposed concentrically about the rotation axis C10, and is capable of moving the holding finger 2 forward and backward relative to the process chambers 24 or the load lock stations by causing the first arm 56 and the second arm 57 to perform a rotational operation. In the handling robot 55 of the present embodiment, since the first arm 56 and the second arm 57 perform a rotational operation about the separate rotation axes C8 and C9 serving as the centers of rotation, respectively, the first arm 56 and the second arm 57 are parallel to each other in plan view, and are capable of performing a rotational operation to rotation positions where the first arm 56 and the second arm 57 are parallel to the straight line L0. Therefore, when the axis-to-axis distances of the arms 6, 7, 56, and 57 are equal, the holding finger 2 can be moved over a longer distance than in the first embodiment.

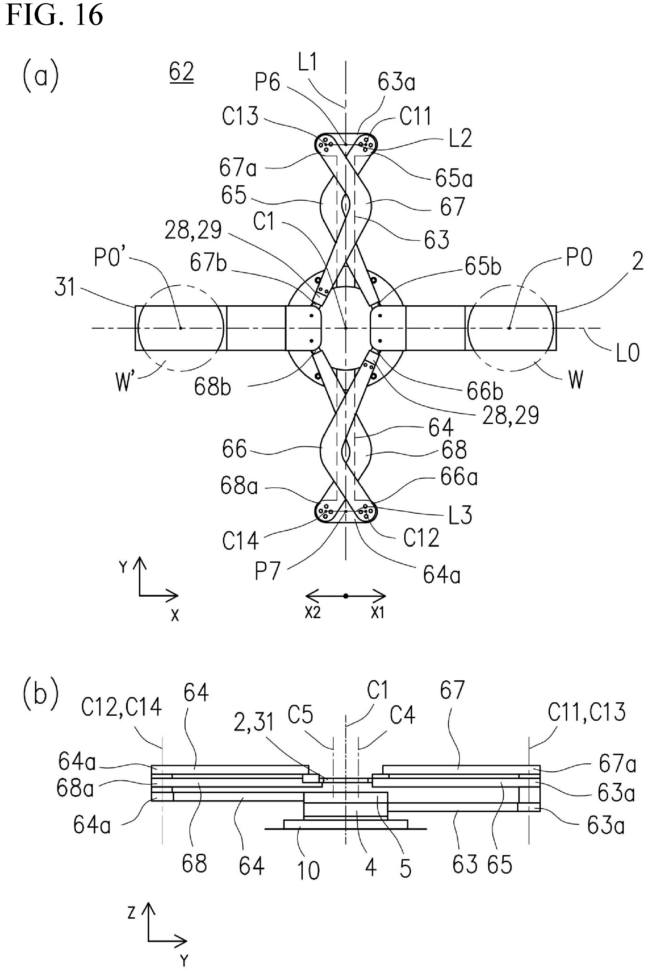

Fig. 16 is a view illustrating a handling robot 62, which is a fourth embodiment of the invention. The handling robot 62 of the present embodiment includes a first arm 63 having a proximal end portion fixed to the first direct drive motor 4 and having a shape in which a distal end portion 63a branches in a T shape in plan view, and a second arm 64 having a proximal end portion fixed to the second direct drive motor 5 and having a shape in which a distal end portion 64a branches in a T shape in plan view. In the handling robot 62 of the present embodiment, a proximal end portion 65a of a first link 65 is connected to one branch of the distal end portion 63a of the first arm 63 so as to be rotatable about a rotation axis C11 serving as the center of rotation, and a proximal end portion 67a of a third link 67 is connected to the other branch of the distal end portion 63a of the first arm 63 so as to be rotatable about a rotation axis C13 serving as the center of rotation. In addition, a proximal end portion 66a of a second link 66 is connected to one branch of the distal end portion 64a of the second arm 64 so as to be rotatable about a rotation axis C12 serving as the center of rotation, and a proximal end portion 68a of a fourth link 68 is connected to the other branch of the distal end portion 64a of the second arm 64 so as to be rotatable about a rotation axis C14 serving as the center of rotation. In addition, each of the first link 65 and the third link 67 connected to the distal end portion 63a of the first arm 63 and the second link 66 and the fourth link 68 connected to the distal end portion 64a of the second arm 64 has a portion curved in a direction opposite to a forward rotation direction.

Incidentally, other configurations provided in the handling robot 62 of the present embodiment are the same as those of the handling robot 30 of the second embodiment. For example, the first holding finger 2 is connected to a distal end portion 65b of the first link 65 and a distal end portion 66b of the second link 66, and the second holding finger 31 is connected to a distal end portion 67b of the third link 67 and a distal end portion 68b of the fourth link 68. The center point P0 of the workpiece W held by the first holding finger 2 and the center point P0' of the workpiece W' held by the second holding finger 31 are located on the straight line L0 passing through the rotation axis C1 and extending in the X1 direction in plan view. In addition, the first link 65 and the second link 66 are disposed at height positions different from each other in the vertical direction, and the third link 67 and the fourth link 68 are disposed at height positions different from each other in the vertical direction. Furthermore, the first link 65 and the third link 67, which are disposed at positions symmetrical to each other with respect to the straight line L1 passing through the rotation axis C1 and extending in the Y direction in plan view, are disposed at height positions different from each other in the vertical direction, and the second link 66 and the fourth link 68, which are disposed at positions symmetrical to each other with respect to the straight line L1 passing through the rotation axis C1 and extending in the Y direction in plan view, are disposed at height positions different from each other in the vertical direction. With the above-described configuration, when the first holding finger 2 and the second holding finger 31 are moved forward and backward, the respective links 65, 66, 67, and 68 do not collide with each other.

As illustrated in Fig. 16(a), when the first arm 63 and the second arm 64 of the handling robot 62 are at the origin position, the rotation axis C11 and the rotation axis C13 are disposed in parallel in the X direction in plan view, and a straight line L2 connecting the rotation axis C11 and the rotation axis C13 is parallel to the straight line L0 extending in the X direction. In addition, the rotation axis C12 and the rotation axis C14 are disposed in parallel in the X direction in plan view, and a straight line L3 connecting the rotation axis C12 and the rotation axis C14 is parallel to the straight line L0 extending in the X direction. In addition, in plan view, a midpoint P6 of the straight line L2 connecting the rotation axis C11 and the rotation axis C13 and a midpoint P7 of the straight line L3 connecting the rotation axis C12 and the rotation axis C14 are configured to be located on the straight line L1 passing through the rotation axis C1 and extending in the Y direction.

Of the rotation axes C11 and C13 disposed at the distal end portion 63a of the first arm 63, the rotation axis C11 is disposed on a side (X1 side) where the first holding finger 2 is disposed with respect to the straight line L1 as a boundary, and the rotation axis C13 is disposed on a side (X2 side) where the second holding finger 31 is disposed. Similarly, of the rotation axes C12 and C14 disposed at the distal end portion 64a of the second arm 64, the rotation axis C12 is disposed on the side (X1 side) where the first holding finger 2 is disposed with respect to the straight line L1 as a boundary, and the rotation axis C14 is disposed on the side (X2 side) where the second holding finger 31 is disposed.

Since the rotation axis C11 of the first link 65 ₌and the rotation axis C12 of the second link 66 are disposed closer to a direction in which the first holding finger 2 moves forward (X1 direction), and the rotation axis C13 of the third link 67 and the rotation axis C14 of the fourth link 68 are disposed closer to a direction in which the second holding finger 31 moves forward (X2 direction), when the first arms 6 and 63 and the second arms 7 and 64 perform a rotational operation through the same rotation angle, the handling robot 62 is capable of moving the holding fingers 2 and 31 forward over a longer distance than the handling robot 30 of the second embodiment.

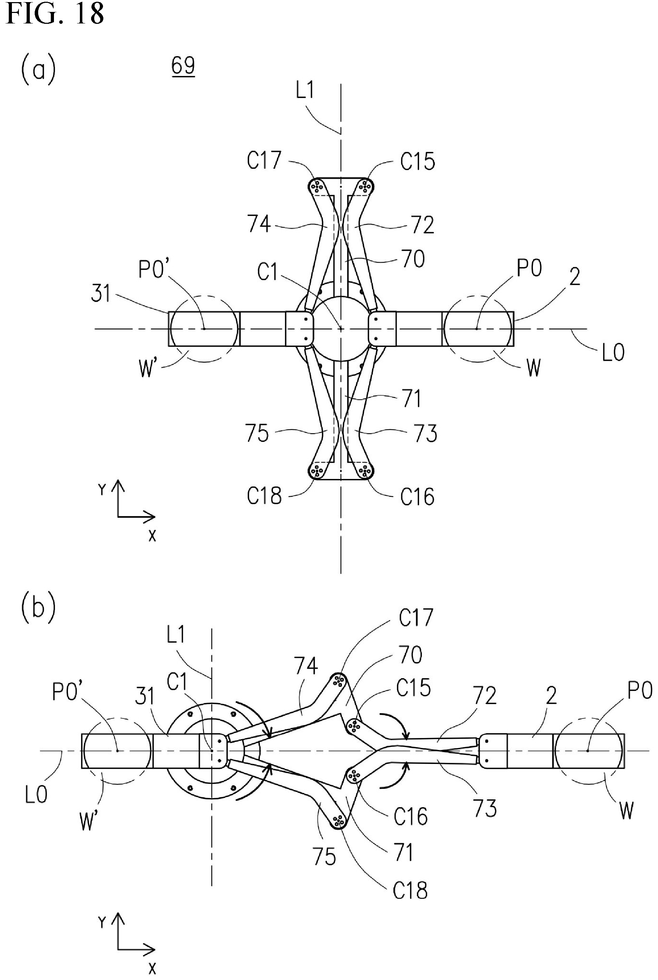

In the above-described embodiment, the first link 65 and the third link 67, which are located at positions symmetrical to each other, and the second link 66 and the fourth link 68, which are located at positions symmetrical to each other, are disposed at height positions different from each other in the vertical direction; however, the invention is not limited to this configuration. Fig. 18 is a view illustrating a handling robot 69, which is another embodiment of the invention. The handling robot 69 of the present embodiment is configured such that a first link 72 and a third link 74, and a second link 73 and a fourth link 75 are disposed at the same height position.

In addition, the handling robot 69 includes a first arm 70 and a second arm 71, each having a shape in which a distal end portion branches in a T shape. A proximal end portion of the first link 72 is connected to one branch of the distal end portion of the first arm 70 so as to be rotatable about a rotation axis C 15 serving as the center of rotation, and a proximal end portion of the third link 74 is connected to the other branch of the distal end portion of the first arm so as to be rotatable about a rotation axis C 17 serving as the center of rotation. A proximal end portion of the second link 73 is connected to one branch of the distal end portion of the second arm 71 so as to be rotatable about a rotation axis C 16 serving as the center of rotation, and a proximal end portion of the fourth link 75 is connected to the other branch of the distal end portion of the second arm 71 so as to be rotatable about a rotation axis C 18 serving as the center of rotation. Furthermore, each of the links 71, 72, 73, and 74 has a portion curved in a direction opposite to a forward rotation direction.

Here, as illustrated in Fig. 18(a), when the handling robot 69 of the present embodiment is at the origin position, the first link 72 and the third link 74, and the second link 73 and the fourth link 75 are disposed at positions symmetrical to each other with respect to the straight line L1 extending in the Y direction in plan view, and further, the first link 72 and the third link 74, and the second link 73 and the fourth link 75 are disposed at positions not overlapping each other in plan view. In order to prevent the links 72 and 74 and the links 73 and 75 located at symmetrical positions from overlapping each other in plan view, the first arm 70 and the second arm 71 are configured such that, as compared with the first arm 63 and the second arm 64, a separation distance between the rotation axes C15 and C17 is set to be larger than a separation distance between the rotation axes C11 and C13, and a separation distance between the rotation axes C16 and C18 is set to be larger than a separation distance between the rotation axes C12 and C14. Incidentally, in order to avoid overlapping of the respective links 72, 73, 74, and 75, the curvature of each of the links 72, 73, 74, and 75 in a horizontal plane may be set to be small so as to have a shape closer to a straight line.

With the above-described configuration, the first link 72 and the third link 74, which are located at positions symmetrical to each other, and the second link 73 and the fourth link 75, which are located at positions symmetrical to each other, can be located at the same height in the vertical direction. Incidentally, by adjusting the first link 72 and the second link 73, and the third link 74 and the fourth link 75 to be at height positions different from each other in the vertical direction, the first link 72 and the second link 73, and the third link 74 and the fourth link 75 do not collide with each other during forward rotation. Therefore, the first holding finger 2 and the second holding finger 31 can be transported over a longer distance.

The embodiments of the invention have been described above in detail with reference to the drawings; however, the invention is not limited to the above-described embodiments, and can be variously modified without departing the concept of the invention. For example, in the above-described embodiments, a semiconductor wafer has been described as an example; however, the invention is not limited thereto, and can also be applied to, for example, a rectangular panel for a flat panel display and the like.

## Claims

1. A handling robot comprising:
a first arm and a second arm, each having a proximal end portion coupled to a drive mechanism;
a first link having a proximal end portion rotatably connected to a distal end portion of the first arm;
a second link having a proximal end portion rotatably connected to a distal end portion of the second arm; and
a first holding finger for holding a workpiece,
wherein each of a distal end portion of the first link and a distal end portion of the second link is rotatably connected to a proximal end portion of the first holding finger,
the first link and the second link are disposed at height positions different from each other in a vertical direction, and
each of the first link and the second link has a shape including a portion curved in a direction opposite to a forward rotation direction for moving the first holding finger forward in plan view.

2. The handling robot according to claim 1, further comprising:
a third link having a proximal end portion rotatably connected to the distal end portion of the first arm;
a fourth link having a proximal end portion rotatably connected to the distal end portion of the second arm; and
a second holding finger for holding a workpiece,
wherein each of a distal end portion of the third link and a distal end portion of the fourth link is rotatably connected to a proximal end portion of the second holding finger,
the third link and the fourth link are disposed at height positions different from each other in the vertical direction, and
each of the third link and the fourth link has a shape including a portion curved in a direction opposite to a forward rotation direction for moving the second holding finger forward in plan view.

3. The handling robot according to claim 2,
wherein the first link and the third link are disposed at height positions different from each other in the vertical direction, and
the second link and the fourth link are disposed at height positions different from each other in the vertical direction.

4. The handling robot according to any one of claims 1 to 3,
wherein a shape of the curved portion has a portion extending in the direction opposite to the forward rotation direction and a portion extending in the forward rotation direction in plan view.

5. The handling robot according to any one of claims 1 to 3,
wherein the curved portion has an arc shape in plan view.

6. The handling robot according to any one of claims 1 to 3,
wherein the first link and the second link have shapes symmetrical to each other in plan view.

7. The handling robot according to claim 2 or 3,
wherein the third link and the fourth link have shapes symmetrical to each other in plan view.

8. The handling robot according to claim 2,
wherein the third link has a shape symmetrical to the first link in plan view, and
the fourth link has a shape symmetrical to the second link in plan view.

9. The handling robot according to claim 2,
wherein each of the first link and the third link is connected to the distal end portion of the first arm so as to be rotatable about a common rotation axis serving as a center of rotation, and
each of the second link and the fourth link is connected to the distal end portion of the second arm so as to be rotatable about a common rotation axis serving as a center of rotation.

10. The handling robot according to claim 2,
wherein the first arm has the distal end portion branching, the proximal end portion of the first link is connected to one branch of the distal end portion of the first arm, and the proximal end portion of the third link is connected to the other branch of the distal end portion of the first arm, and
the second arm has the distal end portion branching, the proximal end portion of the second link is connected to one branch of the distal end portion of the second arm, and the proximal end portion of the fourth link is connected to the other branch of the distal end portion of the second arm.

11. The handling robot according to claim 10,
wherein the first link and the third link are disposed at the same height position, and
the second link and the fourth link are disposed at the same height position.

12. The handling robot according to claim 1 or 2,
wherein the drive mechanism includes a first direct drive motor and a second direct drive motor as drive sources,
the first arm is driven by the first direct drive motor,
the second arm is driven by the second direct drive motor, and
the first direct drive motor and the second direct drive motor are configured to rotate about a common rotation axis serving as a center of rotation.

13. The handling robot according to claim 1 or 2,
wherein the first drive mechanism includes a solid shaft rotatable about a rotation axis serving as a center of rotation and extending in the vertical direction,
the second drive mechanism includes a hollow shaft rotatable about the rotation axis serving as the center of rotation and extending in the vertical direction,
the solid shaft and the hollow shaft are disposed coaxially with respect to the rotation axis,
the proximal end portion of the first arm is fixed to a distal end portion of the solid shaft, and
the proximal end portion of the second arm is fixed to a distal end portion of the hollow shaft.

14. The handling robot according to claim 1 or 2,
wherein a first drive mechanism includes a first shaft rotatable about a first rotation axis serving as a center of rotation and extending in the vertical direction,
a second drive mechanism includes a second shaft rotatable about a second rotation axis serving as a center of rotation and extending in the vertical direction,
the proximal end portion of the first arm is fixed to a distal end portion of the first shaft, and
the proximal end portion of the second arm is fixed to a distal end portion of the second shaft.

15. A transfer chamber,
wherein the handling robot according to claim 1 or 2 is provided in an internal space of the transfer chamber.

16. A semiconductor manufacturing apparatus comprising:
the transfer chamber according to claim 15.
